# EUROPÄISCHE PATENTANMELDUNG

(11) **EP 4 300 082 A1**
(43) Veröffentlichungstag der Anmeldung: **03.01.2024**
(21) Anmeldenummer: 22181889.1
(22) Anmeldetag: 29.06.2022
(51) Int. Cl.: G01N 21/88, G01N 21/956, G01R 31/309, G01N 21/64, G01N 21/94, G01N 21/84

(54) **VERSCHMUTZUNGSERKENNUNG BEI ELEKTRISCHEN BAUGRUPPEN DURCH FLUORESZENTE BESCHICHTUNG**

(71) Anmelder: Siemens Aktiengesellschaft, 80333 München (DE)
(72) Erfinder: Bormann, Ulf, 90518 Altdorf (DE); Scheibner, Dirk, 90473 Nürnberg (DE); Schimmer, Jürgen, 90473 Nürnberg (DE); Zettner, Jürgen, 90587 Veitsbronn (DE)
(74) Vertreter: Siemens Patent Attorneys

(57) **Zusammenfassung**

Die Verschmutzungserkennung bei elektrischen Baugruppen (1) soll vereinfacht und verbessert werden. Dazu wird ein Verfahren zum Überprüfen einer elektrischen Baugruppe (1) auf Verschmutzung mit folgenden Schritten vorgeschlagen:
- Aufbringen einer lumineszierenden Beschichtung (5) auf die elektrische Baugruppe (1),
- Applizieren einer elektromagnetischen Strahlung auf die elektrische Baugruppe (1),
- Erfassen der von der lumineszierenden Beschichtung (5) ausgesendeten elektromagnetischen Strahlung,
- Auswerten der erfassten elektromagnetischen Strahlung,
- Erzeugen einer von einem Ergebnis der Auswertung abhängigen Reaktion.

Konkret kann durch die Beleuchtung einer fluoreszierenden Beschichtung (5) der elektrischen Baugruppe (1) und das Erfassen und Auswerten des Nachleuchtens der fluoreszierenden Beschichtung (5) in einfacher und kostengünstiger Weise auf den Grad der Verschmutzung der elektrischen Baugruppe (1) geschlossen werden.

## Beschreibung

Die Erfindung betrifft ein Verfahren zum Überprüfen einer elektrischen Baugruppe auf Verschmutzung. Ferner betrifft die Erfindung ein System zum Überprüfen einer elektrischen Baugruppe auf Verschmutzung.

Verschmutzung auf elektrischen Baugruppen stellt insbesondere in staubigen Umgebungen wie Zementindustrie, Bergbau etc., aber auch in vielen anderen industriellen Umgebungen ein Problem dar. Auch im maritimen Umfeld können Rückstände zu Schäden führen.

Besonders problematisch sind leitfähige Ablagerungen wie Ruß oder Salz, die insbesondere Kurzschlüsse bei elektrischen, insbesondere elektronischen Baugruppen auslösen können.

Generell führen starke Verschmutzungen zu elektrischen Problemen wie Kriechstrecken, Störungen bei hochohmigen Signalpfaden sowie thermischen Problemen (schlechtere Entwärmung) bis hin zum Ausfall elektrischer Baugruppen und damit oftmals ganzer Geräte.

Häufig sind Verschmutzungen in geschlossenen Gehäusen nur schwer bzw. mit hohem Aufwand zu erkennen, z.B. durch:
- Optische Inspektion - jedoch aufwendig und in der Regel nicht im Betrieb möglich. Das Gerät muss dazu geöffnet werden.
- Indirekt über eine steigende Bauteiltemperatur - ein derartiges Monitoring ist nicht überall möglich und liefert auch nur ein Indiz. Eine erhöhte Bauteiltemperatur kann auch betriebsbedingte Ursachen haben.
- Zusätzliche Sensorik zur Detektion von Ablagerungen, z.B. optisch, resistiv oder kapazitiv auf einer Platine - diese benötigt Platz, deckt nicht die gesamte Baugruppe ab und insb. bei Hochvoltbaugruppen ist eine aufwendige Potentialtrennung nötig.

Es ist ferner bekannt, die Auswirkungen von Verschmutzung durch "conformal coating" oder "Verguss" zu reduzieren.

Die Patentschrift DE 10 2004 018 578 B4 beschreibt eine Messung der Oberflächenleitfähigkeit zur Erfassung des Verschmutzungsgrades einer elektronischen Baugruppe. Diese Vorgehensweise ist stark von der Art und insbesondere der Leitfähigkeit der Schmutzpartikel abhängig und daher häufig nicht zielführend.

Eine Aufgabe der vorliegenden Erfindung ist es, die Verschmutzungserkennung bei elektrischen Baugruppen zu vereinfachen und zu verbessern.

Diese Aufgabe wird gelöst durch ein Verfahren mit den in Patentanspruch 1 angegebenen Verfahrensschritten, also durch ein Verfahren zum Überprüfen einer elektrischen Baugruppe auf Verschmutzung mit folgenden Schritten:
- Aufbringen einer lumineszierenden Beschichtung auf die elektrische Baugruppe,
- Applizieren einer elektromagnetischen Strahlung auf die elektrische Baugruppe,
- Erfassen der von der lumineszierenden Beschichtung ausgesendeten elektromagnetischen Strahlung,
- Auswerten der erfassten elektromagnetischen Strahlung,
- Erzeugen einer von einem Ergebnis der Auswertung abhängigen Reaktion.

Die zu überprüfende elektrische (insbesondere elektronische) Baugruppe kann nur teilweise mit einer lumineszierenden Beschichtung versehen werden. Insbesondere werden dabei die Bereiche der Baugruppe mit einer lumineszierenden Beschichtung versehen, die ein besonders hohes Risiko für eine Verschmutzung aufweisen, z.B. auf Grund von Lüftungsschlitzen oder Lüftern, oder die besonders kritisch bzgl. der Verschmutzung sind, z.B. Prozessoren, bei denen bei starker Verschmutzung eine Überhitzung droht.

Vorteilhaft wird jedoch zumindest ein Großteil der Oberfläche der Baugruppe bzw. die gesamte Oberfläche der Baugruppe mit einer lumineszierenden Beschichtung versehen.

Die elektromagnetische Strahlung, die auf die elektrische Baugruppe (insb. den beschichteten Bereich) appliziert (ausgestrahlt) wird, hat eine geeignete Wellenlänge, die bei der lumineszierenden Beschichtung ihrerseits zum Aussenden einer elektromagnetischen Strahlung, insbesondere Licht, führt.

Beispielsweise führt die Beleuchtung einer mit einer fluoreszierenden Schicht versehenen Baugruppe zu fluoreszierendem (fluoreszentem) Nachleuchten.

Die von der lumineszierenden Beschichtung ausgesendete elektromagnetische Strahlung wird mittels einer geeigneten, für den betreffenden Frequenzbereich sensitiven Sensoreinrichtung, insbesondere einem optischen Sensor wie einem Photodetektor oder einer Kamera erfasst.

Anschließend erfolgt eine Auswertung der erfassten elektromagnetischen Strahlung, insbesondere ein Vergleich mit Referenzdaten, die sowohl den "Gutfall" (keine Verschmutzung bzw. Verschmutzung unkritisch) als auch den "Schlechtfall" (starke bzw. kritische Verschmutzung) abbilden können.

Danach erfolgt eine von dem Ergebnis der Auswertung abhängige Reaktion. Insbesondere dann wenn eine starke Verschmutzung erkannt wird, erfolgt beispielsweise eine entsprechende Information an einen Benutzer, z.B. mittels einer Bildschirmausgabe oder eines optischen und/oder akustischen Warnsignals.

Eine zusätzliche oder alternative Reaktion könnte darin bestehen, dass aktiv und automatisch in den Betrieb der elektrischen Baugruppe eingegriffen wird. Beispielsweise könnte die Baugruppe abgeschaltet oder mit einem niedrigeren Takt betrieben werden.

Die Erfindung ermöglicht eine einfache, kostengünstige und zuverlässige Überwachung einer elektrischen Baugruppe auf Verschmutzung, bei der insbesondere keine Unterbrechung des Betriebs oder das Öffnen eines Gehäuses durch einen Benutzer notwendig sind.

Die erfindungsgemäße Überwachung erfolgt berührungslos. Insbesondere bei Hochvoltbaugruppen entfällt daher eine aufwendige Potentialtrennung.

Die Erfindung erlaubt ein Online-Monitoring im Betrieb der elektrischen Baugruppe.

Die Auswertung im Betrieb liefert Zusatzinformation zu Schwachstellen im Design, insbesondere die Lüftung betreffend, und in der Wartung (Luftfilter defekt, falsch eingebaut, Undichtheiten im Gehäuse etc.).

Weiterhin ist im Zusammenhang mit der Erfindung kein Verguss notwendig, der Reparaturen an der Baugruppe erschwert.

Bei der Lumineszenz wird ein physikalisches System durch von außen zugeführter Energie in einen angeregten Zustand versetzt und emittiert beim Übergang in seinen Grundzustand unter Aussendung von Photonen Licht, inklusive Strahlung außerhalb des sichtbaren Bereichs.

Wenn zwischen der Absorption der Energie und der Emission kein Aktivierungsprozess stattfindet, dann spricht man von Fluoreszenz; wenn ein angeregter Zwischenzustand die Energie für eine gewisse Zeit "einfrieren" kann, dann von Phosphoreszenz.

Fluoreszenz ist die spontane Emission von Licht kurz nach der Anregung eines Materials durch Licht. Dabei sind die emittierten Photonen in der Regel energieärmer als die vorher absorbierten.

Fluoreszenz oder Phosphoreszenz sind somit spezielle Varianten einer Lumineszenz und von letzterer umfasst.

Eine Ausführungsform der Erfindung sieht vor, dass zum Überprüfen einer elektrischen Baugruppe eine fluoreszierende Beschichtung auf die elektrische Baugruppe aufgebracht wird.

Fluoreszierende Beschichtungen sind einfach und kostengünstig herstellbar und auch die Sensorik zum Erfassen der Fluoreszenz ist kostengünstig am Markt verfügbar. Dies trifft insbesondere für Kameras im sichtbaren Wellenbereich zu.

Eine Ausführungsform der Erfindung sieht vor, dass ein Lack mit lumineszierenden, insbesondere fluoreszierenden (fluoreszenten) Pigmenten auf die elektrische Baugruppe aufgebracht wird.

Die Erfindung ist insbesondere auch einsetzbar zur Qualitätskontrolle von beschichteten Leiterplatten oder beschichteten Baugruppen. Ein lumineszierender bzw. fluoreszierender Lack kann zur Kontrolle der Bedeckung mit dem Lack dienen.

Das Aufbringen eines lumineszierenden bzw. fluoreszierenden Lacks ist einfach, schnell und kostengünstig möglich und führt so nicht zu einer wesentlichen Verteuerung der betreffenden Baugruppe.

Besonders vorteilhaft wird zur Überwachung von Platinen ein sowieso häufig auf Platinen aufgetragener, im Zusammenhang mit der Erfindung mit lumineszierenden bzw. fluoreszierenden Pigmenten versehener Lötstopplack auf die betreffenden Platinen aufgebracht. Es ist daher weder eine zusätzliche Beschichtung noch ein zusätzlicher Arbeitsgang bei der Herstellung einer im Zusammenhang mit der Erfindung geeigneten Beschichtung erforderlich.

Eine Ausführungsform der Erfindung sieht vor, dass die lumineszierende Beschichtung auf die elektrische Baugruppe aufgesprüht wird. Die Beschichtung kann damit besonders schnell und kostengünstig auf die Baugruppe aufgebracht werden, insbesondere wenn zum Aufsprühen ein geeignetes Spray verwendet wird. Ggf. kann die Beschichtung damit in vorteilhafter Weise auch bei bereits bestehenden Baugruppen, d.h. nach deren Herstellung, nachträglich aufgebracht werden.

Eine Ausführungsform der Erfindung sieht vor, dass eine Bestrahlungseinrichtung, insbesondere eine Beleuchtungseinrichtung, insbesondere eine Lampe, zum Applizieren der elektromagnetischen Strahlung auf die elektrische Baugruppe (zum Beleuchten der elektrischen Baugruppe) von der elektrischen Baugruppe umfasst ist. Dies ist in der Regel eine kostengünstigere Variante gegenüber der Bereitstellung einer separaten Baugruppe zur Bestrahlung bzw. Beleuchtung.

Die Beleuchtungseinrichtung kann auch eine Vielzahl an Lichtquellen, z.B. eine Vielzahl von auf einer Platine der elektrischen Baugruppe angeordneten, insbesondere darin integrierte LEDs umfassen.

Ebenso sieht eine bevorzugte Ausführungsform der Erfindung vor, dass eine bzw. die Sensoreinrichtung zum Erfassen der von der lumineszierenden Beschichtung ausgesendeten elektromagnetischen Strahlung von der elektrischen Baugruppe umfasst ist. Auch dies stellt in der Regel eine kostengünstigere Variante gegenüber der Bereitstellung einer separaten Baugruppe zum Erfassen der von der lumineszierenden Beschichtung ausgesendeten elektromagnetischen Strahlung dar.

Eine Ausführungsform der Erfindung sieht vor, dass das Auswerten der erfassten elektromagnetischen Strahlung einen Vergleich mit einer bei einer wenigstens im Wesentlichen unverschmutzten elektrischen Baugruppe erfassten elektromagnetischen Strahlung umfasst. Der Vergleich betrifft insbesondere die Leuchtstärke oder den zeitlichen Verlauf des Abklingens der gemessenen Strahlung.

Beispielsweise erfolgt die Auswertung einer Fluoreszenz-Antwort mit bekannten Methoden der Bildauswertung und des maschinellen Lernens. Dabei deutet eine Veränderung bzw. Abnahme des Nachleuchtens entweder generell oder auch lokal in bestimmten Bereichen der Baugruppe auf eine zunehmende Verschmutzung hin. Neben der Leuchtstärke kann auch das zeitliche Verhalten des Abklingens ausgewertet werden.

Aus dem Vergleich mit einem Referenzobjekt lassen sich unerwünschte Abweichungen in der Regel besonders gut erkennen.

Besonders vorteilhaft erfolgt das Auswerten der erfassten elektromagnetischen Strahlung unter Verwendung einer künstlichen Intelligenz (KI), insbesondere eines neuronalen Netzwerks.

Durch das Trainieren einer KI anhand einer Vielzahl an Vergleichsobjekten kann eine besonders gute, zuverlässige und effiziente Auswertung erfolgen.

Die Auswertung kann dahingehend erfolgen, dass eine einen regulären Betrieb der elektrischen Baugruppe verhindernde Verschmutzung festgestellt wird oder keine derartige Verschmutzung festgestellt wird.

Die Auswertung kann jedoch auch dahingehend erfolgen, dass zwischen mehreren Graden der Verschmutzung unterschieden wird. Letzteres hat den Vorteil, dass sich eine unzulässige Verschmutzung in der Regel über einen längeren Zeitraum aufbaut. Der Benutzer wird daher über eine über einen längeren Zeitraum erfolgende Zunahme des Grades der Verschmutzung rechtzeitig vor einer möglichen, unzulässigen Verschmutzung gewarnt und nicht davon überrascht.

Die eingangs gestellte Aufgabe wird ferner gelöst durch ein System zum Überprüfen einer elektrischen Baugruppe auf Verschmutzung nach Anspruch 10, d.h. ein System, umfassend:
- eine auf die elektrische Baugruppe aufgebrachte lumineszierenden Beschichtung,
- eine Bestrahlungseinrichtung zum Applizieren einer elektromagnetischen Strahlung auf die elektrische Baugruppe,
- eine Sensoreinrichtung zum Erfassen der von der lumineszierenden Beschichtung ausgesendeten elektromagnetischen Strahlung,
- eine Auswerteeinrichtung zum Auswerten der erfassten elektromagnetischen Strahlung,
- eine Reaktionseinrichtung zum Erzeugen einer von einem Ergebnis der Auswertung abhängigen Reaktion.

Auf eine erkannte, nicht unerhebliche Verschmutzung kann in unterschiedlicher Weise reagiert werden. Beispielsweise kann der Betrieb der elektrischen Baugruppe automatisch geändert werden, z.B. indem die elektrische Baugruppe oder ein Gerät, welches die elektrische Baugruppe umfasst, automatisch abgeschaltet wird. Die Reaktionseirichtung bewirkt automatisch den geänderten Betrieb, z.B. das Abschalten.

Die Reaktionseirichtung kann auch als Informationseinrichtung zum Erzeugen einer einen Verschmutzungsgrad der elektrischen Baugruppe betreffenden Information anhand der Auswertung ausgebildet sein.

Das erfindungsgemäße System zum Überprüfen einer elektrischen Baugruppe auf Verschmutzung sieht insbesondere vor, dass die Bestrahlungseinrichtung zum Applizieren der elektromagnetischen Strahlung auf die elektrische Baugruppe von der elektrischen Baugruppe umfasst ist.

Ferner sieht das erfindungsgemäße System vor, dass die Sensoreinrichtung zum Erfassen der von der lumineszierenden Beschichtung ausgesendeten elektromagnetischen Strahlung von der elektrischen Baugruppe umfasst ist.

Weiterhin umfasst das erfindungsgemäße System vorteilhaft ein reflektierendes Gehäuse, welches die von der Bestrahlungseinrichtung erzeugte elektromagnetische Strahlung und/oder die von der lumineszierenden Beschichtung ausgesendete elektromagnetische Strahlung reflektiert.

Darüber hinaus umfasst die Auswerteeinrichtung vorteilhaft Mittel einer künstlichen Intelligenz, insbesondere ein neuronales Netzwerk.

Eine Ausführungsform des erfindungsgemäßen Systems sieht eine (insbesondere aus Sicht der betreffenden Baugruppe bzw. des betreffenden Gerätes externe) Datenbank vor, auf deren Daten die Auswerteeinrichtung zum Auswerten der erfassten elektromagnetischen Strahlung zugreift und/oder in der von der Informationseinrichtung erzeugte Daten hinterlegt sind.

Dadurch kann die Auswertung auf eine große Datenbasis gestützt werden.

Die Erfindung wird nachfolgend anhand von Ausführungsbespielen exemplarisch näher beschrieben und erläutert. Dabei zeigen:
- FIG 1: Ein erfindungsgemäßes System zum Überprüfen einer elektrischen Baugruppe auf Verschmutzung,
- FIG 2: ein erfindungsgemäßes System mit einer teilweise verschmutzten elektrischen Baugruppe,
- FIG 3: Verfahrensschritte bei der Durchführung eines erfindungsgemäßen Verfahrens.

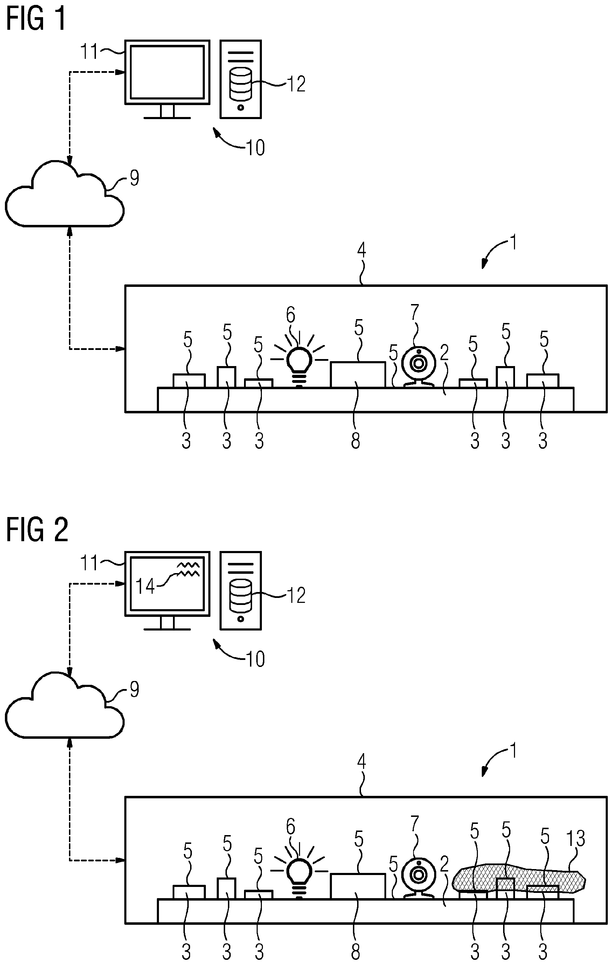

In FIG 1 zeigt in schematisierter, stark vereinfachter Darstellung ein System zum Überprüfen einer elektrischen Baugruppe 1 auf Verschmutzung. Die elektrische Baugruppe 1 umfasst eine Platine 2, auf der eine Anzahl elektrischer, insbesondere elektronischer, Bauelemente 3 platziert ist.

Die elektrische Baugruppe 1 umfasst ferner ein Gehäuse 4, welches die elektrische Baugruppe 1 umgibt. Zur Entwärmung sind in der elektrischen Baugruppe 1 Lüftungsschlitze (nicht dargestellt) vorhanden. Insbesondere durch diese Lüftungsschlitze, aber auch durch andere Gehäuse-Öffnungen, kann Schmutz (Staub, Granulat, Fasern etc.) in das Gehäuse 4 eindringen und sich auf der Oberfläche der Platine 2 oder der Bauelemente 3 ablagern.

Die dargestellte elektrische Baugruppe 1 sieht Mittel zum Erkennen einer Verschmutzung vor. Diese umfassen einerseits eine auf der Oberfläche der Platine 2 sowie der elektronischen Bauelemente 3 aufgebrachte, lumineszierende, insbesondere fluoreszierende, in der Regel verhältnismäßig dünn ausgeführte und daher anhand der Zeichnung nicht direkt ersichtliche Beschichtung 5, die z.B. bei der Herstellung der elektrischen Baugruppe 1 in Form eines geeigneten Lacks auf die Platine bzw. die darauf angebrachten elektrischen Bauelemente 3 aufgesprüht wurde. Vorteilhaft enthält die Beschichtung 5 fluoreszierende Pigmente, so dass die Beschichtung 5 bei geeigneter Beleuchtung selbst zum Aussenden von Licht angeregt wird.

Zur Beleuchtung befindet sich auf der elektrischen Baugruppe 1, insbesondere direkt auf der Platine 2, eine Bestrahlungseinrichtung zum Applizieren einer elektromagnetischen Strahlung auf die elektrische Baugruppe, insbesondere eine Lampe 6, die Licht geeigneter Wellenlänge aussendet, um beim Auftreffen des Lichts auf die fluoreszierende Beschichtung 5 diese zum Leuchten anzuregen.

Zum Erfassen des von der fluoreszierenden Beschichtung 5 erzeugten Lichts ist eine Sensoreinrichtung zum Erfassen des von der fluoreszierenden Beschichtung 5 ausgesendeten Lichts in Form einer Kamera 7 vorhanden. Auch die Kamera 7 ist im Ausführungsbeispiel von der elektrischen Baugruppe 1 umfasst und ist vorteilhaft ebenfalls direkt auf der Platine 2 angebracht.

Alternativ könnte die Beleuchtungseinrichtung (z.B. die Lampe 6) und/oder die Sensoreinrichtung (z.B. die Kamera 7) auch außerhalb der Platine 2 angebracht sein, beispielsweise an dem Gehäuse 4.

Vorteilhaft werden die Beleuchtungseinrichtung (z.B. die Lampe 6) und/oder die Sensoreinrichtung (z.B. die Kamera 7) derart an oder in der Umgebung der elektrischen Baugruppe 1 platziert, dass sie selbst möglichst gut vor einer Verschmutzung geschützt sind, z.B. möglichst weit entfernt von Lüftungsschlitzen oder bei einem regulären Gebrauch der elektrischen Baugruppe 1 in "hängender" Einbaulage.

Die Kamera 7 ist für das von der fluoreszierenden Beschichtung 5 ausgehende Licht sensitiv.

Vorteilhaft ist die Innenseite des Gehäuses 4 der elektrischen Baugruppe 1 reflektierend ausgebildet, so dass das von der fluoreszierenden Beschichtung 5 ausgehende Licht daran reflektiert wird. Die Kamera 7 kann somit zumindest auch von der fluoreszierenden Beschichtung 5 emittiertes Licht erfassen, das nicht auf direktem Weg von der Kamera 7 erfasst werden kann.

Weiterhin umfassts die elektrischen Baugruppe 1 eine Auswerteeinrichtung 8 in Form eines integrierten Schaltkreises (ICs) 8, in dem die von der Kamera 7 erzeugten Bilddaten direkt ausgewertet werden können. Insbesondere findet dabei ein Vergleich mit Referenzdaten statt, die das Kamerabild bei einer unverschmutzten elektrischen Baugruppe 1 widerspiegeln. Diese Ausführungsform bietet den Vorteil, dass alle wesentlichen Bauelemente (Beleuchtung, Sensorik, Auswerteelektronik) auf der zu prüfenden elektrischen Baugruppe 1 vorhanden sind und damit ggf. auf externe Mittel komplett verzichtet werden kann.

Ergibt die Auswertung mittels der Auswerteeinrichtung 8, dass zumindest ein Teilbereich der elektrischen Baugruppe 1 von Verschmutzung betroffen ist, so wird von der Auswerteeinrichtung 8 ein entsprechendes Informationssignal erzeugt und mittels einer über ein Netzwerk 9, z.B. das Internet, mit der elektrischen Baugruppe 1 verbundenen Recheneinrichtung 10, z.B. einen PC 10, an einen Benutzer ausgegeben.

Dies ist in FIG 2 veranschaulicht. Im Unterschied zu FIG 1 befinden sich nun im rechten Bereich der elektrischen Baugruppe 1 Schmutzpartikel 13 in größerem Ausmaß auf den dort befindlichen elektrischen Bauelementen 3. Dadurch wird die Oberfläche der Bauelemente 3 in diesem Bereich nicht mehr beleuchtet und die fluoreszierende Beschichtung 5 emittiert in diesem Bereich auch kein Licht. Somit "fehlt" dieser Bereich in dem von der Kamera 7 erzeugten Kamerabild.

Die Auswerteeinrichtung 8 vergleicht das zuletzt erzeugte Kamerabild mit einem zuvor von einer bzw. der nicht verschmutzten Baugruppe 1 erzeugten Referenzbild und erkennt anhand des Vergleichs aus dem Kamerabild im Bereich der Schmutzpartikel 13 eine wesentliche (nicht unerhebliche), möglicherweise die Funktion der Baugruppe 1 beeinflussende Verschmutzung. Daraufhin erzeugt die Auswerteeinrichtung 8 ein entsprechendes Informationssignal, aus dem ein Warnsignal 14 auf dem Monitor 11 des PC 10 zur Information eines Benutzers resultiert.

Vorteilhaft umfasst der PC 10 eine Datenbank 12, in der Referenzdaten für eine große Anzahl zu der elektrischen Baugruppe 1 vergleichbarer oder baugleicher elektrischer Baugruppen gespeichert sind. Auf diese Datenbank kann die Auswerteeinrichtung 8 zugreifen. Insbesondere verwendet die Auswerteeinrichtung 8 Mittel einer künstlichen Intelligenz (KI) um zwischen einer "normalen" Verschmutzung, die kein Warnsignal hervorruft, und einer kritischen Verschmutzung mit einem entsprechenden Warnsignal zu unterscheiden.

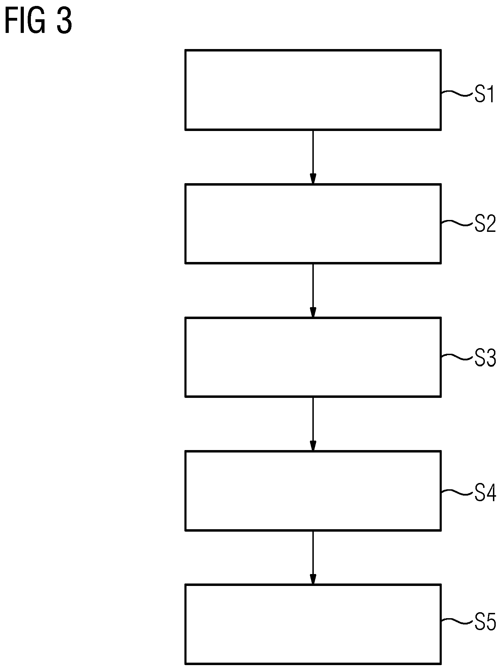

Nachfolgend werden die wesentlichen Verfahrensschritte bei der Durchführung eines erfindungsgemäßen Verfahrens nochmals in Form eines Ablaufdiagramms gemäß FIG 3 verdeutlicht.

In einem ersten Verfahrensschritt S1 wird zum Überprüfen einer elektrischen Baugruppe auf Verschmutzung eine lumineszierende, insbesondere eine fluoreszierende Beschichtung auf die elektrische Baugruppe aufgebracht, z.B. durch Besprühen mit einem fluoreszierende Pigmente enthaltenden Lack.

In einem zweiten Verfahrensschritt S2 wird die elektrische Baugruppe beleuchtet.

In einem dritten Verfahrensschritt S3 wird das in Folge der Beleuchtung in Schritt S2 von der fluoreszierenden Beschichtung ausgesendete Licht erfasst, insbesondere mittels einer geeigneten Kamera.

In einem vierten Verfahrensschritt S4 wird das erfasste Licht, insbesondere das erzeugte Kamerabild ausgewertet (analysiert), insbesondere mit Referenzbildern verglichen.

In einem fünften Verfahrensschritt S5 erfolgt eine von dem Ergebnis der Auswertung abhängige Reaktion, z.B. die Ausgabe eines Informationssignals (insbesondere Warnsignals) an einen Benutzer oder ein von dem Grad einer erkannten Verschmutzung abhängiger Betrieb der elektrischen Baugruppe, z.B. ein Abschaltbetrieb im Fall einer erkannten, starken Verschmutzung.

## Patentansprüche

1. Verfahren zum Überprüfen einer elektrischen Baugruppe (1) auf Verschmutzung mit folgenden Schritten:
- Aufbringen einer lumineszierenden Beschichtung (5) auf die elektrische Baugruppe (1),
- Applizieren einer elektromagnetischen Strahlung auf die elektrische Baugruppe (1),
- Erfassen der von der lumineszierenden Beschichtung (5) ausgesendeten elektromagnetischen Strahlung,
- Auswerten der erfassten elektromagnetischen Strahlung,
- Erzeugen einer von einem Ergebnis der Auswertung abhängigen Reaktion.

2. Verfahren zum Überprüfen einer elektrischen Baugruppe (1) nach Anspruch 1, wobei eine fluoreszierende Beschichtung (5) auf die elektrische Baugruppe (1) aufgebracht wird.

3. Verfahren zum Überprüfen einer elektrischen Baugruppe (1) nach Anspruch 1 oder 2, wobei ein Lack mit lumineszierenden, insbesondere fluoreszenten Pigmenten auf die elektrische Baugruppe (1) aufgebracht wird.

4. Verfahren zum Überprüfen einer elektrischen Baugruppe (1) nach einem der vorherigen Ansprüche, wobei ein Lötstopplack auf die elektrische Baugruppe (1) aufgebracht wird.

5. Verfahren zum Überprüfen einer elektrischen Baugruppe (1) nach einem der vorherigen Ansprüche, wobei die lumineszierende Beschichtung (5) auf die elektrische Baugruppe aufgesprüht wird.

6. Verfahren zum Überprüfen einer elektrischen Baugruppe (1) nach einem der vorherigen Ansprüche, wobei eine Bestrahlungseinrichtung (6) zum Applizieren der elektromagnetischen Strahlung auf die elektrische Baugruppe (1) von der elektrischen Baugruppe (1) umfasst ist.

7. Verfahren zum Überprüfen einer elektrischen Baugruppe (1) nach einem der vorherigen Ansprüche, wobei eine Sensoreinrichtung (7) zum Erfassen der von der lumineszierenden Beschichtung (5) ausgesendeten elektromagnetischen Strahlung von der elektrischen Baugruppe (1) umfasst ist.

8. Verfahren zum Überprüfen einer elektrischen Baugruppe (1) nach einem der vorherigen Ansprüche, wobei das Auswerten der erfassten elektromagnetischen Strahlung einen Vergleich mit einer bei einer wenigstens im Wesentlichen unverschmutzten elektrischen Baugruppe (1) erfassten elektromagnetischen Strahlung umfasst.

9. Verfahren zum Überprüfen einer elektrischen Baugruppe (1) nach einem der vorherigen Ansprüche, wobei das Auswerten der erfassten elektromagnetischen Strahlung unter Verwendung einer künstlichen Intelligenz erfolgt.

10. System zum Überprüfen einer elektrischen Baugruppe (1) auf Verschmutzung, umfassend:
- eine auf die elektrische Baugruppe (1) aufgebrachte lumineszierenden Beschichtung (5),
- eine Bestrahlungseinrichtung (6) zum Applizieren einer elektromagnetischen Strahlung auf die elektrische Baugruppe (1),
- eine Sensoreinrichtung (7) zum Erfassen der von der lumineszierenden Beschichtung (5) ausgesendeten elektromagnetischen Strahlung,
- eine Auswerteeinrichtung (8) zum Auswerten der erfassten elektromagnetischen Strahlung,
- eine Reaktionseinrichtung zum Erzeugen einer von einem Ergebnis der Auswertung abhängigen Reaktion.

11. System zum Überprüfen einer elektrischen Baugruppe (1) auf Verschmutzung nach Anspruch 10, wobei die Bestrahlungseinrichtung (6) zum Applizieren der elektromagnetischen Strahlung auf die elektrische Baugruppe (1) von der elektrischen Baugruppe (1) umfasst ist.

12. System zum Überprüfen einer elektrischen Baugruppe (1) auf Verschmutzung nach Anspruch 10 oder 11, wobei die Sensoreinrichtung (7) zum Erfassen der von der lumineszierenden Beschichtung (5) ausgesendeten elektromagnetischen Strahlung von der elektrischen Baugruppe (1) umfasst ist.

13. System zum Überprüfen einer elektrischen Baugruppe (1) auf Verschmutzung nach einem der Ansprüche 10 bis 12, umfassend ein reflektierendes Gehäuse (4), welches die von der Bestrahlungseinrichtung (6) erzeugte elektromagnetische Strahlung und/oder die von der lumineszierenden Beschichtung (5) ausgesendete elektromagnetische Strahlung reflektiert.

14. System zum Überprüfen einer elektrischen Baugruppe (1) auf Verschmutzung nach einem der Ansprüche 10 bis 13, wobei die Auswerteeinrichtung (8) Mittel einer künstlichen Intelligenz umfasst.

15. System zum Überprüfen einer elektrischen Baugruppe (1) auf Verschmutzung nach Anspruch 14, wobei die Mittel einer künstlichen Intelligenz ein neuronales Netzwerk umfassen.

16. System zum Überprüfen einer elektrischen Baugruppe (1) auf Verschmutzung nach einem der Ansprüche 10 bis 15, umfassend eine Datenbank (12), auf deren Daten die Auswerteeinrichtung (8) zum Auswerten der erfassten elektromagnetischen Strahlung zugreift und/oder in der von der Informationseinrichtung erzeugte Daten hinterlegt sind.
